Europäisches Patentamt

European Patent Office

Office européen des brevets

(11) Publication number: **0 098 662**
**B1**

(12) **EUROPEAN PATENT SPECIFICATION**

(45) Date of publication of patent specification: **14.10.87**

(51) Int. Cl.⁴: **H 03 F 3/08,** H 04 B 9/00, G 08 C 23/00

(21) Application number: **83200988.0**

(22) Date of filing: **02.07.83**

(54) **Infra-red receiver front end.**

(30) Priority: **09.07.82 US 396553**

(43) Date of publication of application:
**18.01.84 Bulletin 84/03**

(45) Publication of the grant of the patent:
**14.10.87 Bulletin 87/42**

(84) Designated Contracting States:
**DE FR GB**

(56) References cited:
**EP-A-0 014 350**
**DE-B-2 536 330**
**GB-A-2 068 689**
**US-A-3 714 591**
**US-A-4 029 976**
**IEEE INTERNATIONAL SOLID STATE CIRCUIT
CONFERENCE, vol. 25, 11 February 1982, New
York G.F. WILLIAMS "Wide-dynamic-range
fiber optic receivers", pages 160-161**
**ELECTRONIC DESIGN, vol. 30, no. 6, 18 March
1982, Denville R. ALLAN "Fiber optics goes aloft
in full production tactical military plane"**

(73) Proprietor: **MOTOROLA, INC.**
**1303 East Algonquin Road
Schaumburg, Illinois 60196 (US)**

(72) Inventor: **DeWeck, Lionel
Montde Vaux
Echichens Vaud (CH)**

(74) Representative: **Ibbotson, Harold
Motorola Ltd Patent and Licensing Operations ·
Europe Jays Close Viables Industrial Estate
Basingstoke Hampshire RG22 4PD (GB)**

(56) References cited:
**ELECTRONICS LETTERS, vol. 15, no. 20,
September 1979 K. OGAWA et al. "GaAs F.E.T.
transimpedance front-end design for a
wideband optical receiver", pages 650-651**
**GRUNDIG TECHNISCHE INFORMATIONEN,
vol. 25, no. 2, 1978 G. BÖHM et al. "Infrarot-
Fernbedienung 160", pages 88-94 * Page 91,
figure 8; page 92, figure 9 ***

Courier Press, Leamington Spa, England.

**Description**

Technical field

This invention relates to a front end suitable for use in an Infra-Red receiver.

At the present time there is a growing requirement for the development of low cost short range communication systems for remote control. Particular requirements are for the remote control of television receivers and audio systems.

One of the most successful ways of providing this remote control is by the use of infra-red data transmission due to its considerable advantages over other methods. Amongst these advantages are the following:

(a) There is no interference with the rest of the electromagnetic spectrum.

(b) In comparison to radio frequency antennae, or acoustic transducers the infra-red transmitting and receiving elements are small.

(c) When used indoors the radiation is confined to the room where it is generated and causes no interference with similar systems operating in adjacent buildings.

(d) Infra-red radiation propagated through air suffers no significant absorption or scattering.


Background art

A typical infra-red transmission systems includes a transmitter and a receiver. The transmitter has an optical source typically a GAs light emitting diode (LED) whilst the receiver utilizes a photodetector typically a PIN photodiode for converting incident optical power into an electric current.

Infra-red signals received by the receiver are very weak at distance from the source, the output current provided by the photodetector being in the nano ampere range. It is therefore essential to provide a preamplifier in the front end to amplify the weak incoming signals to digital voltage levels.

The sensitivity of the receiver is limited by the noise sources at the front end and therefore it is important that the preamplifier be low noise. Furthermore, when a receiver is used in artificial light or sunlight, a fluctuating infra-red component will be present in the received signal and this must be removed by suitable electrical filtering.

There are two known approaches to the design of preamplifiers for infra-red receivers. In one such approach a high input impedance (HZ) amplifier is used. This amplifier tends to integrate the incoming signals in view of its high input impedance and associated stray capacitance and to compensate for this the preamplifier is followed by an equalizer which has a high pass filter characteristic. A known example of such an arrangement is the Siemens TDA 4050.

A problem arises with the above HZ amplifier approach in that the load for the photodetector diode is usually a RLC tuned circuit in order to enable the preamplifier to have the required band pass filter characteristic at the desired signal frequency. This however requires the use of a coil, which cannot be integrated and therefore when the preamplifier is manufactured as an integrated circuit chip, as is desirable, the coil must be provided as an additional off-circuit component. This coil needs elaborate shielding if installed in a harsh electromagnetic environment. Also a RLC circuit is a relatively selective band pass filter and hence pulse trains, as used in conventional infra-red modulation schemes tend to be stretched due to ringing. This further complicates the reception of comprehensive signals.

An alternative approach is to use a transimpedance TZ amplifier. This has a low input impedance and therefore the photodiode stray capacitance causes no serious signal integration. A problem is caused however by low frequency noise due to background infra-red radiation. The amplifier does not adequately reject this low frequency noise and this tends to upset the bias point at the input to the amplifier.

A front end in accordance with the prior art portion of claim 1 is disclosed in IEEE International Solid State Circuit Conference Volume 25, 11 February 1982 pages 160—161.

The prior art receiver utilises the transimpedance amplifier with feedback to provide wide dynamic range whilst maintaining an adequate bandwidth. The receiver however suffers from the above mentioned disadvantage of not adequately rejecting low frequency and DC light noise.

This problem is overcome in the front end of the invention in which the feedback comprises transadmittance feedback means having a low pass transfer characteristic whereby unwanted signals in the output voltage due to undesirable low frequency components in the input current are reduced.

- The transimpedance amplifier may comprise an operational amplifier have an input fed with the input current and negative feedback means connected between its output and the said input.

The said input of the operational amplifier may be the inverting input.

The negative feedback means may comprise a resistor connected between the output of the amplifier and the inverting input.

The transadmittance feedback path may include an integrating amplifier.

In one embodiment the integrating amplifier may comprise an operational amplifier having an input fed via resistive means from the output of the transimpedance amplifier and capacitive means connected between its output and the said input.

In another embodiment the integrating amplifier may comprise an operational amplifier having an input; capacitive means connected between an output of the amplifier and its input and a switchable capacitor arranged alternately to be charged by a voltage fed from the output of the transimpedance amplifier and to be discharged into the said input of the operational amplifier.

A smoothing filter may be connected to the output of the operational amplifier to reduce noise introduced by switching of the switchable capacitor.

Brief description of drawings

An exemplary embodiment of the invention will now be described with reference to the drawings in which:

Figure 1 is a highly schematic block diagram of one known form of front end for an infra-red receiver;

Figure 2 shows an alternative known form of front end;

Figure 3 is a highly schematic block diagram of a front end in accordance with the present invention.

Figure 4a shows the transimpedance amplifier of Figure 3 in more detail;

Figure 4b is an equivalent circuit of the amplifier of Figure 4a;

Figure 5 shows the transmittance feedback path forming part of the front end of Figure 3.

Figure 6 shows an alternative embodiment of the transmittance feedback path.

Detailed description of the invention

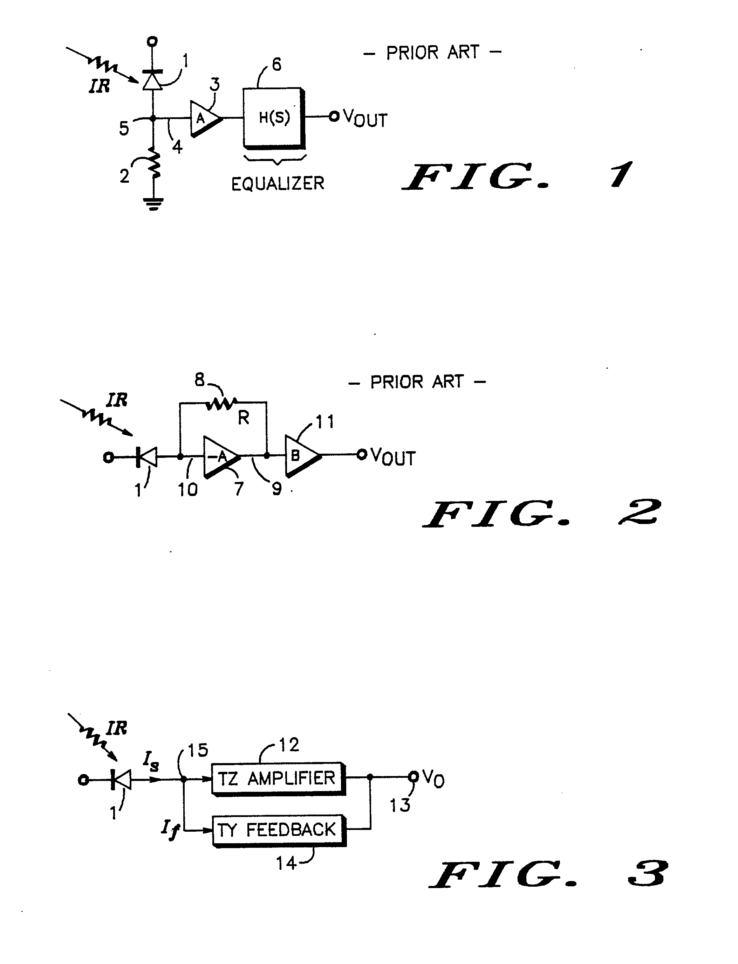

Referring now to Figure 1 of the drawings, infra red radiation falling on a photodetector diode 1 causes a current to flow in this diode. A resistor 2 is connected in series with the diode 1 so that current flowing through the diode also flows through the resistor 2 and generates a potential across it. A high input impedance amplifier 3 has an input 4 which is fed from a junction point 5 between the diode 1 and the resistor 2, with the potential induced across the resistor 2 by the infra-red radiation received by the photodetector diode 1.

As explained above, since the amplifier 3 has a high input impedance, it tends to integrate signals fed to it and therefore to compensate for this the amplifier 3 is connected to feed an equalizer 6. As explained above this front end has operational disadvantages and also is not easy to produce as an integrated circuit.

In Figure 2 there is shown an alternative known front end circuit in which current produced by the photodetector diode 1 on irradiation by infra-red radiation is fed directly to a low input impedance transimpedance amplifier formed by an operational amplifier 7 provided with negative feedback in the form of a resistor 8 connected between its output 9 and its inverting input 10. A further amplifier 11 provides additional amplification. Since the input impedance of the transimpedance amplifier of Figure 2 is low, the stray capacitance of the diode 1 causes no serious signal integration. However, the front end does not adequately reject low frequency noise due to background infra-red radiation, and this tends to upset the bias point at the input 10 to the amplifier.

The above problems are mitigated by the front end of the present invention which is schematically illustrated in block diagram form in Figure 3 to which reference will now be made. Current induced in the photodetector diode 1, by received infra-red radiation is amplified by a transimpedance amplifier 12 and is fed as an output voltage to an output terminal 13. The use of a transimpedance amplifier 12 which has a low input impedance overcomes the problem of signal integration present with a high input impedance amplifier and in order to control the bias point of the input of the amplifier 12 and to reduce noise due to ambient radiation, a transadmittance feedback path 14 is provided between the output terminal 13 of the amplifier 12 and an input terminal 15 of that same amplifier. The transadmittance feedback path converts a voltage present at the output terminal 13 into a negative feedback current at the input terminal 15 of the amplifier 12.

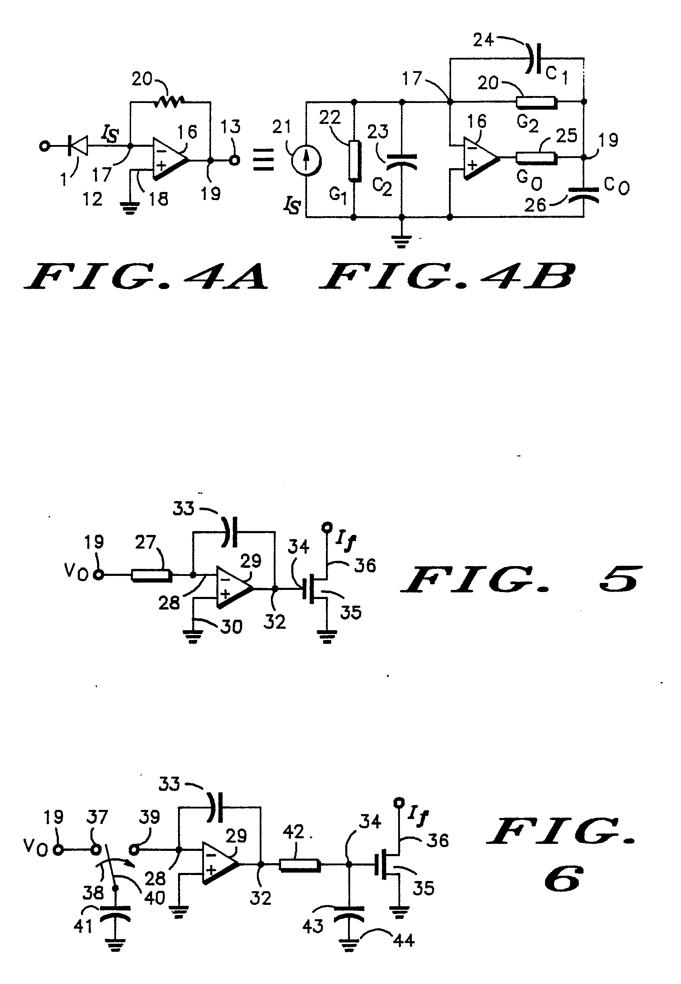

Referring now to Figure 4a there is shown a more detailed schematic diagram of the transimpedance amplifier 12. This amplifier comprises an operational amplifier 16 having an inverting input 17 and a non-inverting input 18. The non-inverting input 18 is connected to a reference potential whilst the inverting input 17 is fed with an input current generated by the photodetector diode 1. The amplifier 16 has an output terminal 19 and negative feedback to the inverting input 17 is provided by means of a feedback resistor 20 connected between the output terminal 19 and the inverting input 17 of the amplifier 16.

In order to examine the operational characteristics of the transimpedance amplifier of Figure 4a reference will now be made to the equivalent circuit of this amplifier which is illustrated in Figure 4b. Like parts in Figure 4b to those in Figure 4a bear like reference numerals.

In the equivalent circuit of Figure 4b, the photodetector diode 1 is represented as a current source 21 feeding the inverting input 17 of the amplifier 16. The input impedance of the amplifier is represented by a resistor 22 connected between the terminal 17 and the reference potential and a shunt capacitor 23 connected across the resistor 22. The resistor 20 has a stray capacitance 24 connected in parallel with it. The amplifier 16 has an output impedance represented by a series resistor 25 and a shunt capacitor 26, the capacitor 26 being connected between the output terminal 19 and the reference potential 12.

In analysing this equivalent circuit, the current generator 21 will be assumed to provide a current $I_s$, the resistors 20, 22 and 25 will be represented by their conductances $G_2$, $G_1$ and $G_0$, whilst the capacitances 23, 24 and 26 have designated values $C_1$, $C_2$ and $C_0$. The output voltage appearing at terminal 19 is referenced $V_0$. The gain of the amplifier 16 will be assumed to be 0.

The transimpedance transfer function $A_{iv}$ of the transimpedance amplifier shown at Figure 4a and in equivalent circuit form in Figure 4b is given by

**0 098 662**

$$A_{iv} = \frac{V_o}{I_s} = K_o \frac{S + \omega_z}{S^2 + \omega_p S + \omega_p^2}$$

where S is complex frequency,

$$K_o = \frac{C_2}{d} \text{ and } d = C_0 C_1 + C_2 C_0 + C_2 C_1$$

$$\frac{\omega_p/q_p = C_0 G_1 + C_1 G_2 + C_0 G_2 + C_1 G_2 + C_2 G_1 + G_0(1 - \beta)}{d}$$

$$\omega_p^2 = \frac{G_0 G_1 + G_1 G_2 + G_0 G_2(1 - \beta_0)}{d}$$

$$\omega_z = \frac{G_2 - {}_0 G_0}{C_2}$$

$$q_p = \sqrt{G_0 G_1 + G_1 G_2 + G_0 G_2(1 - \beta_0)} \ d$$

$$C_0 G_1 + G_1 G_0 + C_0 G_2 + C_1 G_2 + C_2 G_1 + C_2 G_0(1 - \beta_0)$$

Under ideal circumstances in which the gain of the amplifier 16 approaches infinity and complex frequency tends to zero, then

$$\lim_{\substack{s \to o \\ \beta \to \infty}} Aiv = \frac{\beta_0}{1 - \beta_0} \frac{G_2/\beta_0 - G_0}{G_0 G_2} = -I/G_2 = -R_2$$

Under these ideal conditions, the transimpedance transfer function can be seen to be dependent only upon the value of the resistor 20.

Referring now to Figure 5, in order to provide the transadmittance feedback path the terminal 19 at the output of the amplifier 16 is coupled via a resistor 27 to an inverting input 28 of an operational amplifier 29 which also has a non-inverting input 30 connected to a reference potential 31.

The operational amplifier 29 has an output terminal 32 and a capacitor 33 is connected across the amplifier 29 between its inverting input 28 and its output terminal 32. In order to convert output voltage provided by the amplifier 29 into a negative feedback current, the output terminal 32 of the amplifier is connected to a gate input 34 of a field effect transistor 35 whose drain electrode 36 provides the feedback current to the transimpedance amplifier. The voltage at the terminal 19 has already been defined as $V_o$. Assume now that the output voltage of the amplifier 29 appearing at the output terminal 32 and hence at the gate input terminal 34 of the transistor 35, is $V_f$ and that output current provided by the drain electrode 36 of the transistor 35 is $I_f$ then

$$\frac{V_f}{V_o} = - \frac{1}{SRC}$$

where R is the resistance of the resistor 27, and C is the capacitance of the Capacitor 33.

Also $I_f = G_m V_f$ where $G_m$ is the transconductance of the transistor 35

The transadmittance transfer function of the feedback path shown in Figure 5 is then given

$$F_{iv} = \frac{I_f}{V_o} = \frac{G_m}{ST_1}$$

where $T_1 = RC$

Considering now the overall transimpedance $G_{vi}$ of the entire front end circuit as illustrated in Figure 3, and consisting of the transimpedance amplifier 12, with parallel transadmittance feedback amplifier 14, this transimpedance is given by

4

0 098 662

$$G_{vi}= \frac{V_o}{I_s} = \frac{A_{iv}}{1-A_{iv}F_{iv}}$$

Assuming that the current to voltage transfer ratio $A_{iv}$ is purely resistive and equals $R_2$ then $A_{iv}=-R2$.

Assuming the transadmittance feedback amplifier is of the form shown in Figure 5, so that the transadmittance feedback is given by

$$F_{vi}=\frac{G_m}{ST1}$$

then the overall frequency response of the front end circuit is found to be

$$\frac{V_o}{I_s} = -R_2 \frac{ST1}{ST1+G_mR_2} = -R_2 \frac{ST1/\alpha}{ST1/\alpha+1}$$

Where $\alpha$ is the product $G_mR_2$. As can be seen this is the frequency response of a high pass filter, and therefore low frequency noise due to ambient radiation would be blocked.

The implementation of the transadmittance feedback path by the embodiment illustrated in Figure 5 is satisfactory except where a large time constant of integration is required since it is not easy to provide large circuit element values in an integrated circuit. In this case, the transadmittance feedback may be provided by the embodiment illustrated in Figure 6 where like components to those in Figure 5 bear like reference numerals.

In this embodiment the terminal 19 which provides a voltage from the transimpedance amplifier is connected to one terminal 37 of a·switch 38. The switch 38 has a second terminal 39 connected to the input terminal 28 of the operational amplifier 29 and a wiper 40 connected to one terminal of a capacitor 41. The wiper 40 switches between the terminals 37 and 39 such that when connected to the terminal 37 the capacitor 41 is charged by the voltage appearing at the terminal 19 and when the wiper 40 is connected to the other terminal 39 the capacitor 41 discharges into the input terminal 28 of the operational amplifier 29.

By this switching the operational amplifier 29 may be made to operate as an integrating circuit having a relatively high time constant whilst the values of capacitors needed to be used in the circuit are relatively low.

According to the Shannons Theorem a continuous signal which contains no significant frequency component above F HZ may be recovered from its sampled version if the sampling interval is less than 1/2F seconds. In other words, the switching speed of the switch 38 must be at least two times higher than the highest frequency of the infra-red signal handled by the front end circuit.

The sampling effected by the switch 38 also adds switching noise to the wanted signals, and to reduce this noise, it is desirable to provide a smoothing filter after the operational amplifier 29. This is provided by means of a resistor 42 connected between the output terminal 32 of the amplifier 29, and the gate input 34 of the transistor 35, together with a capacitor 43 connected between the gate input 34 and a reference potential 44.

Assuming $\omega$ is very much less than $\omega_s$ where $\omega$ is the angular frequency of the infra red radiation, and $\omega_s$ is the angular switching frequency of the switch 38, then

$$\frac{V_f}{V_o} = - \frac{\alpha}{ST_s}$$

$V_f$ being the voltage appearing at the gate input terminal 34 of the transistor 35, and $T_s$ is the time constant of the smoothing filter formed by the resistor 42 and the capacitor 43.

$$\frac{I_f}{V_f} = G_m$$

and therefore

$$F_{vi}= \frac{I_f}{V_o} = -G_m \frac{\alpha}{ST_s}$$

The use of this switched capacitor technique of Figure 6 allows the fabrication of an integrated circuit transadmittance feedback amplifier having a relatively long time constant of integration without the need to integrate high value capacitances.

5

The invention has been described by way of example and modification may be made without departing from the scope of the invention. In particular the implementation of the transimpedance amplifier and the transadmittance feedback amplifier are given by way of example only and any suitable alternative may of course be employed. For example the transadmittance feedback path may include any kind of frequency selective low pass characteristic with properly chosen cut-off frequencies. Although the front-end circuit has been illustrated in connection with an infra-red receiver utilising a photodetector to provide the input current this is not essential and the input current may be derived from any suitable sensor which may be represented as a current source.

**Claims**

1. A front end circuit suitable for use in an infra-red receiver, the circuit comprising a transimpedance amplifier (12) having an input terminal (15) for receiving an input current and an output terminal (13) for providing an output voltage; feedback means (14) coupled between the output terminal (13) and the input terminal (15) of the transimpedance amplifier (12) characterised in that the feedback means (14) comprises transadmittance feedback means having a low pass transfer characteristic whereby unwanted signals in the output voltage due to undesirable low frequency components in the input current are removed.

2. A front end circuit as claimed in claim 1, wherein the transimpedance amplifier comprises an operational amplifier (16) having an input fed with the input current and a negative feedback means connected between its output and input.

3. A front end circuit as claimed in claim 2, wherein said input is the inverting input of the amplifier.

4. A front end circuit as claimed in claim 3, wherein the negative feedback means comprises a resistor (20) connected between the output of the amplifier and the inverting input.

5. A front end circuit as claimed in claim 1 or 2, wherein the transadmittance feedback means includes an integrating amplifier (29).

6. A front end circuit as claimed in claim 5, wherein the integrating amplifier comprises an operational amplifier (29) having an input fed via resistive means (27) from the output of the transimpedance amplifier, and capacitive means (33) coupled between its output and input.

7. A front end circuit as claimed in claim 5, wherein the integrating amplifier comprises:

an operational amplifier (29) having an input; capacitive means (33) coupled between an output of the amplifier and its input; and

a switchable capacitor (41) arranged alternately to be charged by a voltage fed from the output of the transimpedance amplifier and to be discharged into said input of the operational amplifier.

8. A front end circuit as claimed in claim 7, wherein a smoothing filter (42, 43) is connected to the output of the operational amplifier (29) to reduce noise introduced by switching the switchable capacitor.

9. A front end circuit as claimed in claim 5 and including a voltage to current converter (35) coupled in series with the integrating amplifier (29).

10. A front end circuit as claimed in claim 9 wherein the voltage-to-current converter comprises a transistor (35) having a first electrode (36) coupled to the input terminal (15) of the transimpedance amplifier (12), a second electrode coupled to a reference terminal (44) and a control electrode (34) coupled to the output (32) of the integrating amplifier (29).

**Patentansprüche**

1. Eingangsschaltung zur Verwendung in einem Infrarotempfänger, enthaltend einen Transimpedanzverstärker (12) mit einem Eingangsanschluss (15) zur Aufnahme eines Eingangsstromes und einem Ausgangsanschluss (13) zur Abgabe einer Ausgangsspannung; eine zwischen den Ausgangsanschluss (13) und den Eingangsanschluss (15) des Transimpedanzverstärkers (12) geschaltete Rückkopplungseinrichtung (14), dadurch gekennzeichnet, dass die Rückkopplungseinrichtung (14) eine Transadmittanzrückkopplungseinrichtung ist mit einer Tiefpassübertragungscharakteristik, durch die unerwünsch te Signale in der Ausgangsspannung aufgrund unerwünschter niedriger Frequenzkomponenten im Eingangsstrom unterdrückt werden.

2. Eingangsschaltung nach Anspruch 1, bei der der Transimpedanzverstärker einen Operationsverstärker (16) enthält, mit einem Eingang, dem der Eingangsstrom zugeführt ist, und einer Gegenkopplungseinrichtung, die zwischen seinen Ausgang und den Eingang geschaltet ist.

3. Eingangsschaltung nach Anspruch 2, bei der der genannte Eingang der invertierende Eingang des Verstärkers ist.

4. Eingangsschaltung nach Anspruch 3, bei der die Gegenkopplungseinrichtung ein Widerstand (20) ist, der zwischen den Ausgang des Verstärkers und den invertierenden Eingang geschaltet ist.

5. Eingangsschaltung nach Anspruch 1 oder 2, bei der die Transadmittanzrückkopplungseinrichtung einen integrierenden Verstärker (29) enthält.

6. Eingangsschaltung nach Anspruch 5, bei der der integrierende Verstärker einen Operationsverstärker (29) enthält, mit einem Eingang, der über Widerstandselemente (27) vom Ausgang des Transimpedanzverstärkers angesteuert wird, und kapazitiven Einrichtungen (33), die zwischen seinen Ausgang und seinen Eingang geschaltet sind.

7. Eingangsschaltung nach Anspruch 5, bei der der integrierende Verstärker enthält:

einen Operationsverstärker (29) mit einem Eingang und kapazitiven Einrichtungen (33), die zwischen einen Ausgang des Verstärkers und seinen Eingang geschaltet sind; und

einen schaltbaren Kondensator (41), der so angeordnet ist, dass er alternierend mit einer Spannung geladen wird, die vom Ausgang des Transimpedanzverstärkers zugeführt wird, und in den Eingang des Operationsverstärkers entladen wird.

8. Eingangsschaltung nach Anspruch 7, bei der ein Glättungsfilter (42, 43) mit dem Ausgang des Operationsverstärkers (29) verbunden ist, um Störungen zu vermindern, die durch das Schalten des schaltbaren Kondensators er zeugt werden.

9. Eingangsschaltung nach Anspruch 5 und enthaltend einen Spannungs/Strom-Wandler (35), der in Serie mit dem integrierenden Verstärker (29) geschaltet ist.

10. Eingangsschaltung nach Anspruch 9, bei der der Spannungs/Strom-Wandler einen Transistor (35) enthält, mit einer ersten Elektrode (36), die mit dem Eingangsanschluss (15) des Transimpedanzverstärkers (12) verbunden ist, einer zweiten Elektrode, die mit einem Bezugsanschluss (44) verbunden ist, und einer Steuerelektrode (34), die mit dem Ausgang (32) des integrierenden Verstärkers (29) verbunden ist.

**Revendications**

1. Circuit de tête d'entrée apte à être utilisé dans un récepteur d'infrarouge, ce circuit comprenant: un amplificateur de transimpédance (12) ayant une borne d'entrée (15) pour recevoir le courant d'entrée et une borne de sortie (13) pour fournir une tension de sortie; des moyens de rétroaction (14) couplés entre la borne de sortie (13) et la borne d'entrée (15) de l'amplificateur de transimpédance (12), caractérisé en ce que les moyens de rétroaction (14) comprennent des moyens de rétroaction à transadmittance ayant une caractéristique de tranfert passe-bas, ce qui a pour effet d'éliminer les signaux indésirables dans la tension de sortie, dus à des composantes indésirables à basse fréquence dans le courant d'entrée.

2. Circuit de tête d'entrée selon revendication 1, dans lequel l'amplificateur de transimpédance comprend un amplificateur opérationnel (16) ayant une entrée recevant le courant d'entrée, et un moyen de rétroaction négative connecté entre sa sortie et son entrée.

3. Circuit de tête d'entrée selon revendication 2, dans lequel ladite entrée est l'entrée inverseuse de l'amplificateur.

4. Circuit de tête d'entrée selon revendication 3, dans lequel le moyen de rétroaction négative comporte une résistance (2) connectée entre la sortie de l'amplificateur et l'entrée inverseuse.

5. Circuit de tête d'entrée selon revendication 1 ou 2, dans lequel les moyens de rétroaction à transadmittance comprennent un amplificateur intégrateur (29).

6. Circuit de tête d'entrée selon revendication 5, dans lequel l'amplificateur intégrateur comporte un amplificateur opérationnel (29) ayant une entrée alimentée via des moyens résistifs (27), par la sortie de l'amplificateur de transimpédance, et des moyens capacitifs (33) couplés entre sa sortie et son entrée.

7. Circuit de tête d'entrée selon revendication 5, dans lequel l'amplificateur intégrateur comprend:

— un amplificateur opérationnel (29) ayant une entrée, des moyens capacitifs (33) couplés entre une sortie de l'amplificateur et son entrée; et

— un condensateur commutable (41) agencé tour à tour pour être chargé par une tension fournie par la sortie de l'amplificateur de transimpédance et pour être déchargé dans ladite entrée de l'amplificateur opérationnel.

8. Circuit de tête d'entrée selon la revendication 7, dans lequel un filtre de lissage (42, 43) est relié à la sortie de l'amplificateur opérationnel (29), pour réduire le bruit introduit par la commutation du condensateur commutable.

9. Circuit de tête d'entrée selon revendication 5, comportant un convertisseur tension-courant (35) couplé en série à l'amplificateur intégrateur (29).

10. Circuit de tête d'entrée selon revendication 9, dans lequel le convertisseur tension-courant comprend un transistor (35) ayant une première électrode (36) couplée à la borne d'entrée (15) de l'amplificateur de transimpédance (12), une deuxième électrode couplée à une borne de référence (44) et une électrode de commande (34) couplée à la sortie (32) de l'amplificateur intégrateur (29).

- PRIOR ART -

# FIG. 1

IR

1

5

4

3

A

6

H(S)

2

○ V_OUT

EQUALIZER

- PRIOR ART -

# FIG. 2

IR

8

R

11

B

1

10

7

9

○ V_OUT

-A

IR

$I_s$

15

12

TZ AMPLIFIER

○ V_O

1

13

$I_f$

14

TY FEEDBACK

# FIG. 3

**FIG.4A    FIG.4B**

**FIG. 5**

**FIG. 6**

2